# FASCICULE DE BREVET EUROPEEN

(11) **EP 0 542 856 B1**
(45) Date de publication et mention de la délivrance du brevet: **12.10.1994**
(21) Numéro de dépôt: 91914855.1
(22) Date de dépôt: 06.08.1991
(51) Int. Cl.: G11C 16/06, G11C 29/00, G11C 7/00

(54) **MEMOIRE INTEGREE POURVUE DE MOYENS DE TEST AMELIORES**
INTEGRIERTER SPEICHER MIT VERBESSERTER TESTVORRICHTUNG
INTEGRATED MEMORY HAVING IMPROVED TESTING MEANS

(30) Priorité: 08.08.1990 FR 9010114
(43) Date de publication de la demande: 26.05.1993
(73) Titulaire: SGS-THOMSON MICROELECTRONICS S.A., 94250 Gentilly (FR)
(72) Inventeur: GAULTIER, Jean-Marie, F-13790 Rousset (FR); SILVESTRE DE FERRON, Gérard, F-13710 Fuveau (FR); GASTALDI, Roberto, I-Milano (IT)
(74) Mandataire: Schmit, Christian Norbert Marie
(86) Numéro de dépôt international: FR9100652
(87) Numéro de publication internationale: WO9202934

(56) Documents cités:
- EP-A- 0 241 327
- IEEE JOURNAL OF SOLID CIRCUITS. Vol. 23, No. 5, October 1988, New York US, pages 1150-1156; R. Gastaldi:"A 1-Mbit Coms Eprpm with enhanced verification" see page 1152, left hand column, line 7, right hand column, line 5, fig. 10
- PATENT ABSTRACTS OF JAPAN Vol. 13, No.125 (P-847) 28 March 1989 & JP-A-63293800(TOSHIBA) 30. Nov. 1988

## Description

L'invention concerne les mémoires réalisées en circuit intégré, et notamment les mémoires non volatiles programmables électriquement, effaçables ou non, reprogrammables ou non.

Une mémoire selon le préamble de la revendication 1 est connue de l'article IEEE JOURNAL OF SOLID-STATE CIRCUITS, vol. 23, no. 5 Oct. 1988, New York, USA, pages 1150-1156, R. GASTALDI : " A 1-M bit CMOS EPROM with enhanced verification ".

Un des problèmes que l'on rencontre dans la fabrication des mémoires, lorsqu'elles comportent de très nombreuses cellules, est la nécessité de les tester complètement avant de les livrer.

On teste les mémoires dans leur état vierge, pour vérifier qu'il n'y a strictement aucune cellule mauvaise.

Dans les mémoires programmables électriquement fabriquées aujourd'hui, les cellules sont constituées par des transistors à grille flottante. Lorsque les cellules sont vierges, il n'y a pas de charges stockées dans la grille flottante. Si on polarise la cellule avec des potentiels de lecture appropriés, la cellule doit laisser passer un courant. Si au contraire la cellule est programmée, elle ne laisse plus passer de courant dans les mêmes conditions de polarisation.

Mais le courant qui passe dans une cellule vierge est très faible. Pour le détecter en mode de lecture, on procède par lecture différentielle, par comparaison avec une cellule de référence identique aux cellules de la mémoire. Si on appelle I le courant qui passe en mode de lecture dans une cellule, ce courant I a pour valeur I1 si la cellule est vierge et I2 (pratiquement nul) si la cellule est programmée. On compare, dans un comparateur différentiel de courant, le courant Iref qui passe dans la cellule de référence (vierge) avec un courant qui est la somme I + Ibias du courant I dans la cellule à lire et d'un courant de polarisation Ibias.

Le courant Iref est en principe égal à I1 : courant dans une cellule vierge. La polarisation Ibias est choisie sensiblement égale à (I2-I1)/2, c'est-à-dire en pratique Iref/2 . De cette manière, si le courant I lu dans une cellule est légèrement au dessous de Iref/2, le résultat de la comparaison sera dans un premier sens et on considérera que la cellule est dans l'état programmé; si au contraire le courant I est au dessus de Iref/2, le résultat de la comparaison sera dans l'autre sens et on considérera que la cellule est vierge.

Le courant de polarisation Ibias a donc pour but de faciliter la comparaison entre le courant de la cellule à lire et le courant de la cellule de référence.

Lors du test des mémoires, on effectue la lecture de la mémoire selon le même principe de lecture différentielle.

On s'est aperçu selon l'invention que des mémoires s'avéraient défectueuses à l'usage bien que les cellules aient été testées rigoureusement une à une. On a attribué ces défauts notamment aux mauvais contacts pouvant se produire entre les cellules de mémoire et un conducteur (ligne de bit) auquel ces cellules sont raccordées pour transmettre le courant représentant l'état de la cellule; l'opération de formation de contacts est en effet une opération délicate dans le procédé de fabrication. Non seulement les contacts peuvent être défectueux dès le départ, mais en plus ils peuvent se détériorer par vieillissement (naturel ou forcé).

Un but de l'invention est d'améliorer le test des mémoires pour mieux éliminer les circuits comportant des cellules défectueuses, notamment du point de vue des contacts.

Selon l'invention, on propose que la mémoire soit pourvue de moyens pour donner au courant de polarisation une valeur plus faible en mode de test qu'en mode de lecture normale.

Ainsi, seules les cellules dont le courant de lecture à l'état vierge est suffisamment fort passeront avec succès le test de vérification de l'état vierge; celles qui présentent un courant de lecture trop faible (bien que suffisant en mode de lecture normale) seront rejetées : on considérera que cette valeur trop faible dénote vraisemblablement la présence d'un mauvais contact qui, en vieillissant, risquera de causer un fonctionnement erroné de. la mémoire; on rejettera donc la cellule ou la mémoire.

Ainsi, la mémoire intégrée électriquement programmable selon l'invention, dans laquelle l'état d'une cellule est lu par comparaison entre d'une part un courant absorbé par une cellule de référence et d'autre part la somme du courant absorbé par la cellule à lire et d'un courant de polarisation Ibias produit à l'intérieur du circuit intégré, est essentiellement caractérisée en ce qu'elle comporte des moyens pour réduire, en mode de test, la valeur du courant de polarisation, et pour lire l'état des cellules avec cette valeur réduite du courant de polarisation.

Le courant de polarisation en mode de test est de préférence de l'ordre de la moitié du courant de polarisation en lecture normale.

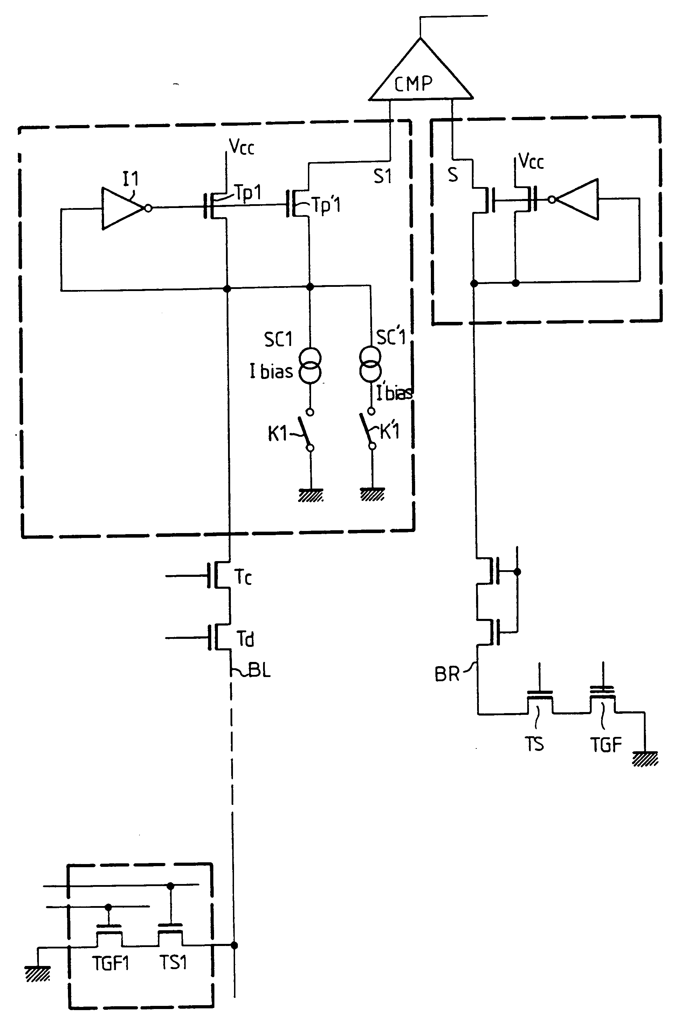

Les caractéristiques et avantages de l'invention apparaîtront à la lecture de la description détaillée qui suit et qui est faite en référence au dessin annexé dans lequel :
- la figure unique représente schématiquement le circuit de lecture de la mémoire selon l'invention.

Sur cette figure, on a représenté simplement une cellule mémoire constituée essentiellement par un transistor à grille flottante TGF1 en série avec un transistor de sélection TS1, et une cellule de référence constituée de manière identique par un transistor à grille flottante TGF en série avec un transistor TS.

La cellule de mémoire à lire est reliée à un conducteur BL appelé "ligne de bit", sur lequel circule le courant absorbé par la cellule lorsqu'elle reçoit les potentiels de lecture appropriés.

La ligne de bit BL est reliée par l'intermédiaire de transistors (Td, Tc) à un circuit de précharge et lecture CPL1. Ce circuit a la fonction suivante : dans une première étape de lecture (phase de précharge), il porte la ligne de bit à un potentiel de précharge fixe; dans une deuxième étape (lecture proprement dite) il détecte le courant qui passe dans la ligne de bit.

De la même manière, la cellule de référence est reliée à un conducteur BR qui transmet à un circuit de précharge et lecture CPL le courant absorbé par la cellule de référence lorsqu'elle reçoit les potentiels de lecture appropriés.

Les transistors Td et Tc sont nécessaires au fonctionnement de la mémoire, notamment pour l'adressage de la ligne de bit reliée à la cellule sélectionnée en lecture. Par raison de symétrie, on a placé des transistors identiques entre le conducteur BR et le circuit de précharge et lecture CPL de la cellule de référence.

Les circuits de précharge et lecture CPL et CPL1 sont constitués de manière à détecter des courants; leurs sorties S et S1 sont reliées chacune à une entrée respective d'un comparateur CMP qui peut fournir un signal fonction de la différence entre les courants détectés par chacun des circuits. Mais, alors que le courant détecté par le circuit CPL est bien le courant absorbé par la cellule de référence, on s'arrange pour que le courant détecté par le circuit CPL1 soit la somme du courant I absorbé dans la cellule à lire et d'un courant de polarisation.

Selon l'invention, le courant de polarisation a une première valeur Ibias en mode de lecture normale de la mémoire, et une deuxième valeur I′bias en mode de test de cellules vierges, cette deuxième valeur étant plus petite que la première. Un commutateur commandé par exemple par une borne de mode de test non représentée permet de passer du courant Ibias au courant I'bias.

En pratique, le courant de polarisation est en effet produit par une source de courant interne au circuit intégré, cette source de courant étant connectée au circuit de précharge et lecture CPL1 ou étant incorporée à ce circuit. On prévoira donc qu'il y a deux sources de courant différentes, par exemple de valeurs I bias et I'bias, que l'on peut connecter alternativement l'une à la place de l'autre selon qu'on est en mode de test ou en mode de fonctionnement normal. Ou encore il y a une première source de courant utilisée en mode de test et une deuxième source utilisée en parallèle avec la première en mode de fonctionnement normal de la mémoire.

Dans la réalisation pratique la plus simple, le circuit de précharge et lecture CPL1 est constitué de la manière suivante : il comporte un transistor de précharge Tp1 dont la source est reliée par les transistors Td et Tc à la ligne de bit et dont le drain est relié à une borne d'alimentation Vcc; il comporte également un inverseur de rebouclage I1 connecté entre la source et la grille du transistor Tpl. Le transistor Tp1 rebouclé par l'inverseur I1 constitue un circuit d'asservissement qui tend à maintenir une tension de précharge fixe sur la ligne de bit.

Le circuit de précharge et lecture comporte encore, pour permettre la lecture du courant I présent sur la ligne de bit, un transistor de recopie T′p1 dont la source et la grille sont reliées respectivement à la source et à la grille du transistor Tp. Le drain de ce transistor constitue la sortie S1 du circuit CPL1 et est relié à une première entrée du comparateur de courant CMP.

Enfin, pour le circuit CPL1, une source de courant SC1 de valeur Ibias est connectée à la source commune des transistors Tp1 et T′p1 pour soustraire de chacun un courant Ibias/2 (en supposant que les transistors Tp1 et T′p1 ont des géométries identiques).

De cette structure il résulte que le courant appliqué à l'entrée du comparateur CMP est égal à (I+Ibias)/2 si les transistors ont même géométrie, I étant le courant absorbé dans la ligne de bit.

Le circuit de précharge et lecture CPL de la cellule de référence est constitué de manière identique à l'exception du fait qu'il n'y a pas de source de courant de polarisation Ibias; par conséquent le courant qui est appliqué à l'autre entrée S du comparateur est Iref/2 si Iref est le courant absorbé à travers la ligne BR par la cellule de référence vierge.

Enfin, le circuit de précharge et lecture CPL1 associé à la ligne de bit BL comporte une autre source de courant SC′1 et un moyen pour commuter l'une au moins des deux sources de courant pour que le courant I′bias ajouté au courant I de la ligne de bit en mode de test soit plus faible que le courant Ibias ajouté en mode de lecture normale.

Dans un exemple de réalisation, le courant I'bias est égal à environ Ibias/2. Mais il pourrait être plus faible ou plus fort.

Sur la figure on a représenté un interrupteur K1 associé à une source de courant SC1 de valeur Ibias et un interrupteur K′1 associé à une source SC′1 de valeur I'bias. Les interrupteurs sont alors commandés en opposition de phase, K1 étant fermé en mode de lecture normal et ouvert en mode de test, K′1 étant fermé en mode de test et ouvert en mode de lecture normal.

Le résultat du test comme celui de la lecture normale est fourni par le comparateur CMP. Les cellules sont déclarées bonnes en mode de test si le courant qui les traverse est supérieur à Iref-I′bias mais pas si ce courant est compris entre Iref-Ibias et Iref-I′bias, alors que pourtant, en mode de lecture normale, ces cellules donneraient un signal correct.

## Revendications

1. Mémoire électriquement programmable en circuit intégré, dans laquelle l'état d'une cellule (TGF1, TS1) est lu par comparaison entre un courant absorbé par une cellule de référence (TGF, TS) et la somme du courant absorbé par la cellule à lire et d'un courant de polarisation complémentaire Ibias produit à l'intérieur du circuit intégré, caractérisé en ce qu'elle comporte des moyens (SC′1, K1, K′1) pour réduire, en mode de test, la valeur du courant de polarisation et pour lire l'état des cellules avec cette valeur réduite de courant de polarisation.

2. Mémoire selon la revendication 1, caractérisée en ce que le courant de polarisation de valeur réduite est de l'ordre de la moitié du courant de polarisation du mode de lecture normale.

## Patentansprüche

1. Elektrisch programmierbarer Speicher in integrierter Schaltung, in dem der Zustand einer Zelle (TGF1, TS1) durch Vergleich zwischen einem durch eine Referenzzelle (TGF, TS) aufgenommenen Strom und der Summe des durch die zu lesende Zelle aufgenommenen Stroms und eines im Inneren der integrierten Schaltung erzeugten komplementären Polarisationsstroms Ibias gelesen wird, dadurch **gekennzeichnet**, daß er Mittel (SC′1, K1, K′1) umfaßt, um in der Test-Betriebsart den Wert des Polarisationsstroms herabzusetzen und um den Zustand der Zellen mit diesem herabgesetzten Polarisationsstromwert zu lesen.

2. Speicher nach Anspruch 1, dadurch **gekennzeichnet**, daß der Polarisationsstrom mit herabgesetztem Wert in der Größe der Hälfte des Polarisationsstroms der Normallese-Betriebsart ist.

## Claims

1. Integrated-circuit electrically programmable memory, in which the state of a cell (TGF1, TS1) is read by comparison between a current absorbed by a reference cell (TGF, TS) and the sum of the current absorbed by the cell to be read and a complementary bias current Ibias produced within the integrated circuit, characterised in that it includes means (SC′1, K1, K′1) for reducing, in test mode, the value of the bias current and for reading the state of the cells with this reduced bias current value.

2. Memory according to Claim 1, characterised in that the reduced bias current is around one half the bias current of the normal read mode.
